# EUROPÄISCHE PATENTSCHRIFT

(11) **EP 0 883 239 B1**
(45) Veröffentlichungstag und Bekanntmachung des Hinweises auf die Patenterteilung: **02.04.2003**
(21) Anmeldenummer: 97108965.1
(22) Anmeldetag: 04.06.1997
(51) Int. Cl.: H03F 1/00, H03F 1/02, H03F 3/45

(54) **Vorverstärker zur Verstärkung von Signalspannungen einer Signalquelle hoher Quellenimpedanz**
Preamplifier for amplifying signal voltages of a signal source with high source impedance
Préamplificateur pour amplifier des signaux de tension d'une source de signal à grande impédance de source

(43) Veröffentlichungstag der Anmeldung: 09.12.1998
(73) Patentinhaber: KROHNE MESSTECHNIK GMBH & CO. KG, 47058 Duisburg (DE)
(72) Erfinder: Van der Pol, Roland, Dipl.-Ing., 5924 AK Venlo (NL)
(74) Vertreter: Patentanwälte Gesthuysen, von Rohr, Weidener, Häckel

(56) Entgegenhaltungen:
- DE-A- 1 918 618
- FR-A- 2 572 604
- US-A- 3 521 179
- US-A- 5 216 382
- HICKMAN I: "BOOTSTRAP BASE TO BRIDGE BUILDING" ELECTRONICS WORLD AND WIRELESS WORLD, Bd. 98, Nr. 1678, 1.Oktober 1992, Seiten 868-870, XP000315544

## Beschreibung

Die Erfindung betrifft einen Vorverstärker zur Verstärkung von Signalspannungen einer Signalquelle hoher Quellenimpedanz mit einem mit der Signalquelle verbundenen Signaleingang, mit einer ersten mit einem ersten Versorgungsspannungspotential verbundenen Versorgungsspannungsklemme, mit einer zweiten mit einem zweiten Versorgungsspannungspotential verbundenen zweiten Versorgungsspannungsklemme und mit einem ein Ausgangssignal liefernden Signalausgang.

Vorverstärker sind aus dem Stand der Technik in großer Anzahl, ausgebildet für die unterschiedlichsten Einsatzbereiche, bekannt. Ein besonderes Problem beim Einsatz von Vorverstärkern tritt in den Fällen auf, in denen die zu verstärkende Signalspannung aus einer Signalquelle mit hoher oder sehr hoher Quellenimpedanz stammt. Man kann beispielsweise feststellen, daß bei der Übertragung relativ niederfrequenter Signale über eine niedrige Koppelkapazität bei herkömmlichen, häufig als Vorverstärker eingesetzten, als Spannungsfolger geschalteten Operationsverstärkern mit hohem Ableitwiderstand schon hohe Signalverluste auftreten. Diese Signalverluste sind selbstverständlich unerwünscht.

Beim Einsatz von Vorverstärkern zur Verstärkung von Signalspannungen einer Signalquelle hoher Quellenimpedanz ist es bekanntermaßen problematisch, daß die Signalspannung aufgrund der hohen bis sehr hohen Quellenimpedanz sehr empfindlich gegenüber äußeren elektrischen Feldern ist. Solche äußeren elektrischen Felder können zu hohen Signalverlusten bereits vor dem Vorverstärker führen.

Aus der US 3,521,179, die einen eingangs beschriebenen, gattungsgemäßen Vorverstärker zeigt, ist es bekannt, daß das erste Versorgungsspannungspotential sowie das zweite Versorgungsspannungspotential abhängig von dem Ausgangssignal parallel verschiebbar sind. Eine wesentliche Verbesserung der Störungsanfälligkeit des Vorverstärkers wird damit jedoch nicht erzielt.

Der Erfindung liegt somit die Aufgabe zugrunde, eine Verbesserung bezüglich der Störungsanfälligkeit des Vorverstärkers anzugeben.

Gemäß der Lehre der Erfindung ist die zuvor aufgezeigte und dargelegte Aufgabe dadurch gelöst, daß mit dem Signalausgang ein Tiefpaßfilter zum Filtern des Ausgangssignals verbunden ist und das erste und zweite Versorgungsspannungspotential abhängig von dem tiefpaßgefilterten Ausgangssignal parallel verschiebbar sind.

Erfindungsgemäß ist erkannt worden, daß die hohen Signalverluste, die beispielsweise bei der Verstärkung einer Signalspannung einer Signalquelle hoher Quellenimpedanz mit Hilfe eines als Spannungsfolger geschalteten Operationsverstärkers auftreten, im wesentlichen darin begründet sind, daß Verlustströme über die parasitären Kapazitäten zwischen dem Signaleingang des Operationsverstärkers und der ersten bzw. zweiten im Stand der Technik auf konstantem Potential liegenden Versorgungsspannungsklemme des Operationsverstärkers abfließen. Diese Verlustströme treten bei anderen bekannten Vorverstärkern in der gleichen Art und Weise auf.

Durch die erfindungsgemäße Kopplung des ersten und zweiten Versorgungsspannungspotentials an das tiefpaßgefilterte Ausgangssignal des Vorverstärkers wird erreicht, daß die Verlustströme über die parasitären Kapazitäten - aufgrund der nur noch reduziert oder überhaupt nicht mehr schwankenden Potentialdifferenzen an den parasitären Kapazitäten - zumindest reduzierbar, wenn nicht vollständig eliminierbar sind.

Praktische Versuche haben gezeigt, daß z. B. bei einer 25 Hz-Signalquelle mit einem in Reihe geschalteten Kondensator einer Kapazität von 10 pF als Quellenimpedanz bei herkömmlichen Vorverstärkern ein Signalverlust von ungefähr 20 % auftritt. Die erfindungsgemäße Verschiebung des ersten und zweiten Versorgungsspannungspotentials abhängig von dem Ausgangssignal des Vorverstärkers führte bei derselben Signalquelle zu einer Reduzierung des Signalverlustes bei der Übertragung auf weniger als 0,01 %.

Der Vorverstärker gemäß der Lehre der Erfindung erfährt eine erste vorteilhafte Ausgestaltung dadurch, daß er als Spannungsfolger ausgebildet ist. Bei einer derartigen Ausgestaltung des Vorverstärkers ist gewährleistet, daß die Verschiebung der Versorgungsspannungspotentiale abhängig von dem Ausgangssignal auch bei einer angestrebten völligen Eliminierung der Einflüsse der parasitären Kapazitäten besonders einfach zu gewährleisten ist.

Dadurch, daß alternativ der Vorverstärker gemäß der Lehre der Erfindung die Signalspannung verstärkt, ergibt sich zwar in der Regel eine schwierigere Realisierung der Verschiebung der Versorgungsspannungspotentiale abhängig von dem tiefpaßgefilterten Ausgangssignal unter der Bedingung reduzierter Verlustströme, gleichzeitig ist jedoch schon in der Vorverstärkungsstufe eine tatsächliche Erhöhung des Signalpegels ohne Signalverluste gewährleistet.

Legt man nun den Vorverstärker gemäß der Lehre der Erfindung so aus, daß das erste und zweite Versorgungsspannungspotential unmittelbar abhängig von dem abgeschwächten Ausgangssignal verschiebbar ist, erreicht man zwar beispielsweise bei einer Abschwächung auf 95 % keine vollständige Eliminierung der parasitären Kapazitäten, jedoch ist in der Regel eine Erhöhung der Stabilität des Vorverstärkers gewährleistet.

Ist der Vorverstärker gemäß der Lehre der Erfindung als Spannungsfolger ausgebildet, so ist es besonders vorteilhaft, den Vorverstärker dadurch auszugestalten, daß das Ausgangssignal unmittelbar als Bezugspotential für die das jeweilige Versorgungsspannungspotential liefernden Versorgungsspannungsquellen dient. Hierdurch ist eine besonders einfache Verschiebung der Versorgungsspannungspotentiale so gewährleistet, daß die Verlustströme über die parasitären Kapazitäten des Vorverstärkers eliminiert sind.

Insbesondere bei der Variante des Vorverstärkers gemäß der Lehre der Erfindung, bei der die Signalspannung gleichzeitig verstärkt wird, ist es besonders vorteilhaft, den Vorverstärker dadurch auszugestalten, daß das jeweilige Versorgungsspannungspotential über einen Spannungsteiler aus dem Ausgangssignal und dem Potential jeweils einer Versorgungsspannungsquelle ableitbar ist. Durch entsprechende Wahl des Spannungsteilers kann somit auch aus einem verstärkten Ausgangssignal das jeweilige Versorgungsspannungspotential so nachgeführt werden, daß der störende Einfluß der parasitären Kapazitäten zumindest weitgehend eliminiert ist.

Besonders einfach gelingt die Realisierung des Vorverstärkers gemäß der ersten Lehre der Erfindung dadurch, daß dieser als Operationsverstärker ausgebildet ist. Bei einem Operationsverstärker ist insbesondere die Einflußnahme auf die Versorgungsspannungspotentiale einfach und mit geringen Rückwirkungen auf das Ausgangssignal verbunden.

Gemäß einer bevorzugten Weiterbildung ist ferner vorgesehen, daß das Potential einer Abschirmung der Signalquelle von dem Ausgangssignal steuerbar ist. Durch diese Ausgestaltung des Vorverstärkers ist gewährleistet, daß äußere Störfelder bzw. parasitäre Kapazitäten zwischen der Signalquelle einerseits und der Umgebung andererseits aufgrund der geringen Quellenimpedanz des Ausgangssignals des Vorverstärkers keinen bzw. nahezu keinen Einfluß auf die Signalspannungen der Signalquelle mit hoher Quellenimpedanz nehmen können.

Gemäß einer ersten alternativen Ausgestaltung des Vorverstärkers nach der Lehre der Erfindung ist die Abschirmung zwischen der Signalquelle und dem Signaleingang angeordnet. Durch diese Anordnung ist gewährleistet, daß auch die Versorgungsspannungspotentiale des Vorverstärkers keinen Einfluß auf die Signalspannungen nehmen können.

Gemäß einer zweiten alternativen Ausgestaltung des Vorverstärkers nach der Lehre der Erfindung ist die Abschirmung im Bereich des Signalausgangs des Vorverstärkers angeordnet, so daß eine Abschirmung der Signalquelle bis hin zum Signaleingang gewährleistet ist.

Im einzelnen gibt es nun eine Vielzahl von Möglichkeiten, den erfindungsgemäßen Vorverstärker zur Verstärkung von Signalspannungen einer Signalquelle hoher Quellenimpedanz auszugestalten und weiterzubilden. Dazu wird verwiesen einerseits auf die dem Patentanspruch 1 nachgeordneten Patentansprüche, andererseits auf die Beschreibung von bevorzugten Ausführungsbeispielen in Verbindung mit der Zeichnung. In der Zeichnung zeigt
- Fig. 1: ein Ausführungsbeispiel eines aus dem Stand der Technik bekannten Vorverstärkers,
- Fig. 2: ein weiteres Ausführungsbeispiel eines Vorverstärkers,
- Fig. 3: ein weiteres Ausführungsbeispiel eines Vorverstärkers,
- Fig. 4: ein weiteres Ausführungsbeispiel eines Vorverstärkers,
- Fig. 5: ein weiteres Ausführungsbeispiel eines Vorverstärkers,
- Fig. 6: ein Ausführungsbeispiel eines Vorverstärkers gemäß der Lehre der Erfindung,
- Fig. 7: ein weiteres Ausführungsbeispiel eines Vorverstärkers,
- Fig. 8: ein weiteres Ausführungsbeispiel eines Vorverstärkers,
- Fig. 9: ein weiteres Ausführungsbeispiel eines Vorverstärkers,
- Fig. 10: ein weiteres Ausführungsbeispiel eines Vorverstärkers,
- Fig. 11: ein weiteres Ausführungsbeispiel eines Vorverstärkers und
- Fig. 12: ein weiteres Ausführungsbeispiel eines Vorverstärkers.

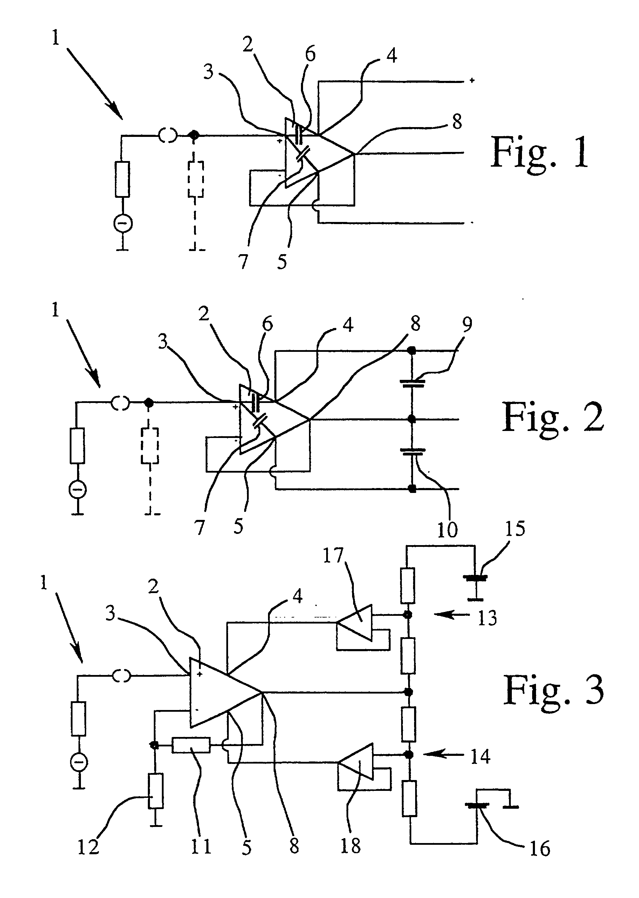

In Fig. 1 ist ein Vorverstärker gezeigt, wie er aus dem Stand der Technik bekannt ist. Wird ein solcher Vorverstärker zur Verstärkung von Signalspannungen einer Signalquelle 1 hoher Quellenimpedanz eingesetzt, so führen die innerhalb des als Operationsverstärker 2 - hier als Spannungsfolger geschaltet-ausgebildeten Vorverstärkers durch die zwischen einem Signaleingang 3 und einer ersten Versorgungsspannungsklemme 4 und einer zweiten Versorgungsspannungsklemme 5 liegenden parasitären Kapazitäten 6, 7 fließenden Verlustströme zu einem erheblichen Signalverlust. In dem Ausführungsbeispiel eines aus dem Stand der Technik bekannten Vorverstärkers ist dieser als Spannungsfolger unter Verwendung des Operationsverstärkers 2 ausgeführt.

In den folgenden Figuren sind die jeweils mit Fig. 1 übereinstimmenden Bauelemente mit den selben Bezugszeichen versehen.

Bei dem in Fig. 2 dargestellten Ausführungsbeispiel eines Vorverstärkers wird der Vorverstärker wiederum von einem als Spannungsfolger geschalteten Operationsverstärker 2 gebildet, an dessen Signaleingang 3 die Signalspannung einer Signalquelle 1 mit hoher Quellenimpedanz anliegt. Auch bei dem in Fig. 2 dargestellten Operationsverstärker 2 sind zwischen dem Signaleingang 3 und der ersten Versorgungsspannungsklemme 4 bzw. der zweiten Versorgungsspannungsklemme 5 parasitäre Kapazitäten 6, 7 vorhanden. Der negative Einfluß der parasitären Kapazitäten auf die Signalspannungen ist jedoch dadurch zumindest stark reduziert, daß das erste und zweite Versorgungsspannungspotential abhängig von dem Ausgangssignal des Vorverstärkers am Signalausgang 8 parallel verschiebbar sind. Dies ist bei diesem Ausführungsbeispiel eines Vorverstärkers dadurch gewährleistet, daß das Ausgangssignal unmittelbar als Bezugspotential für die das jeweilige Versorgungsspannungspotential liefernden Versorgungsspannungsquellen 9, 10 dient.

In Fig. 3 der Zeichnung ist ein weiteres Ausführungsbeispiel eines Vorverstärkers dargestellt, bei welchem der aus einem Operationsverstärker 2 und zwei den Verstärkungsfaktor bestimmenden Widerständen 11, 12 aufgebaute Vorverstärker die Signalspannung verstärkt. Damit trotz dieser Verstärkung des Ausgangssignals gegenüber der Signalspannung die Verlustströme über die parasitären Kapazitäten verhindert werden, ist bei dem in Fig. 3 dargestellten Ausführungsbeispiel das jeweilige Versorgungsspannungspotential über einen Spannungsteiler 13, 14 aus dem Ausgangssignal und dem Potential jeweils einer Versorgungsspannungsquelle 15, 16 ableitbar. Um den Signalausgang 8 des Operationsverstärkers 2 nicht zu stark zu belasten, ist bei dem in Fig. 3 dargestellten Ausführungsbeispiel zwischen dem Mittelabgriff des jeweiligen Spannungsteilers 13, 14 und den zugehörigen Versorgungsspannungsklemmen 4, 5 jeweils ein Spannungsfolger 17, 18 angeordnet.

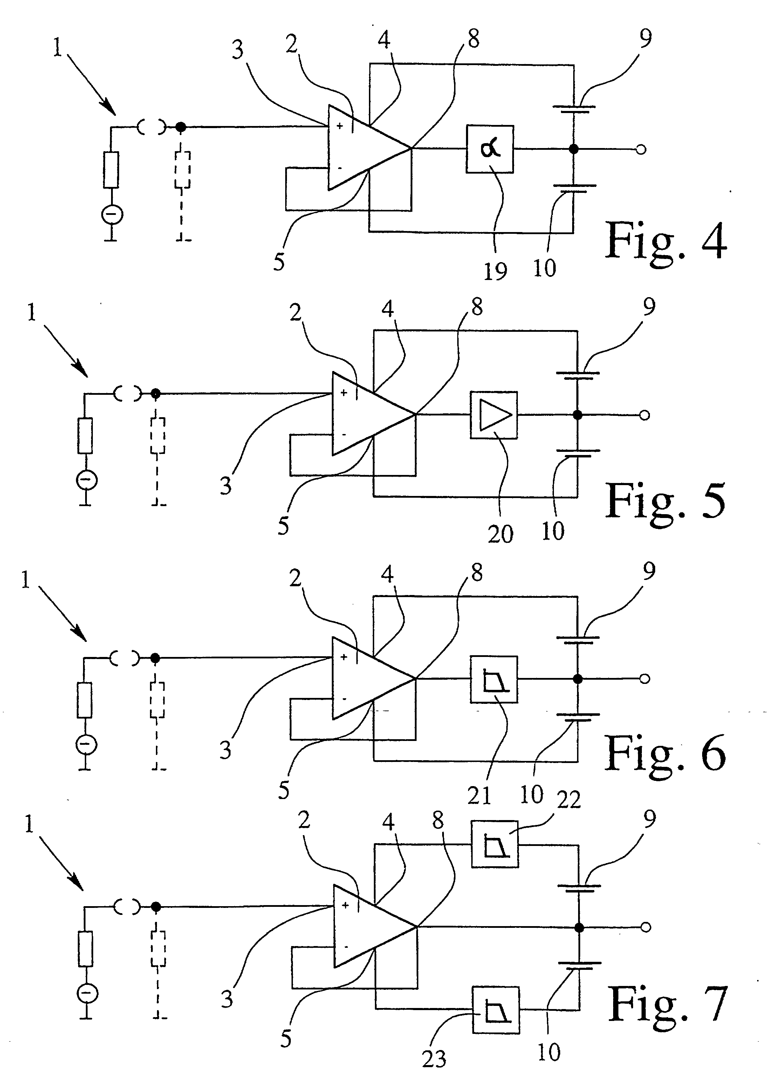

In Fig. 4 der Zeichnung ist ein weiteres Ausführungsbeispiel eines Vorverstärkers dargestellt, bei dem das erste und zweite Versorgungsspannungspotential unmittelbar abhängig von dem abgeschwächten Ausgangssignal verschiebbar ist. Dies wird bei dem in Fig. 4 dargestellten Vorverstärker durch einen vor die nach Art der Fig. 2 geschalteten Versorgungsspannungsquellen 9, 10 geschalteten Abschwächer 19 gewährleistet.

Im Gegensatz dazu zeigt Fig. 5 ein weiteres Ausführungsbeispiel eines Vorverstärkers, bei dem zwar der Operationsverstärker 2 wiederum als Spannungsfolger geschaltet ist, daß am Signalausgang 8 anliegende Ausgangssignal des Operationsverstärkers 2 jedoch in einem Verstärker 20 verstärkt wird, wobei die Versorgungsspannungspotentiale des Operationsverstärkers 2 unmittelbar aus dem verstärkten Ausgangssignal des Operationsverstärkers 2 nach Art des in Fig. 2 dargestellten ersten Ausführungsbeispiels abgeleitet werden.

In Fig. 6 der Zeichnung ist weiter ein Ausführungsbeispiel eines Vorverstärkers nach der Lehre der Erfindung dargestellt, bei welchem das Ausgangssignal mit Hilfe eines mit dem Signalausgang 8 eines als Spannungsfolger geschalteten Operationsverstärkers 2 verbundenen Tiefpaßfilter 21 gefiltert wird. Dieses gefilterte Ausgangssignal dient anschließend als Grundlage der Verschiebung der Versorgungsspannungspotentiale nach der in Fig. 2 dargestellten Art.

Um das bei den in Fig. 6 dargestellten Ausführungsbeispiel auftretende Problem zu vermeiden, daß das Ausgangssignal auch zur Weiterverarbeitung nur mehr durch den Tiefpaßfilter 21 gefiltert vorliegt, sind bei dem in Fig. 7 dargestellten Ausführungsbeispiel nach der Lehre der Erfindung jeweils zwischen den Versorgungsspannungsquellen 9, 10 und den Versorgungsspannungsklemmen 4, 5 zwei separate Tiefpaßfilter 22, 23 angeordnet.

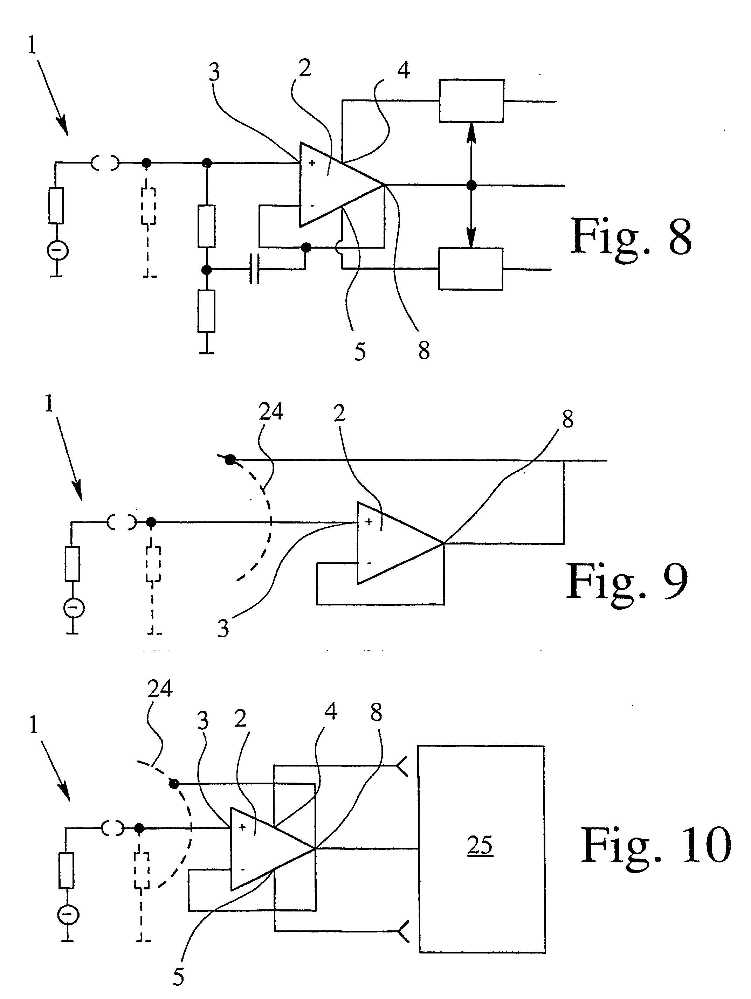

Bei dem in Fig. 8 dargestellten Ausführungsbeispiel weitere bekannte Maßnahmen getroffen, um die Eingangsimpedanz des Vorverstärkers zu erhöhen.

In Fig. 9 der Zeichnung ist nun ein weiteres Ausführungsbeispiel eines Vorverstärkers dargestellt. Bei diesem Vorverstärker ist das Potential einer zwischen der Signalquelle 1 und dem Signaleingang 3 liegenden Abschirmung 24 der Signalquelle 1 von dem Ausgangssignal des Vorverstärkers steuerbar.

Ein weiteres Ausführungsbeispiel eines Vorverstärkers ist in Fig. 10 dargestellt. Hier erfolgt eine parallele Verschiebung der Versorgungsspannungspotentiale abhängig von dem Ausgangssignal nach einem der zuvor beschriebenen Ausführungsbeispiele, hier verwirklicht mit Hilfe einer nur schematisch dargestellte Verschiebeschaltung 25, und gleichzeitig wird eine zwischen der Signalquelle und dem Signaleingang liegende Abschirmung 24 auf das am Signalausgang 8 anliegende Potential angehoben.

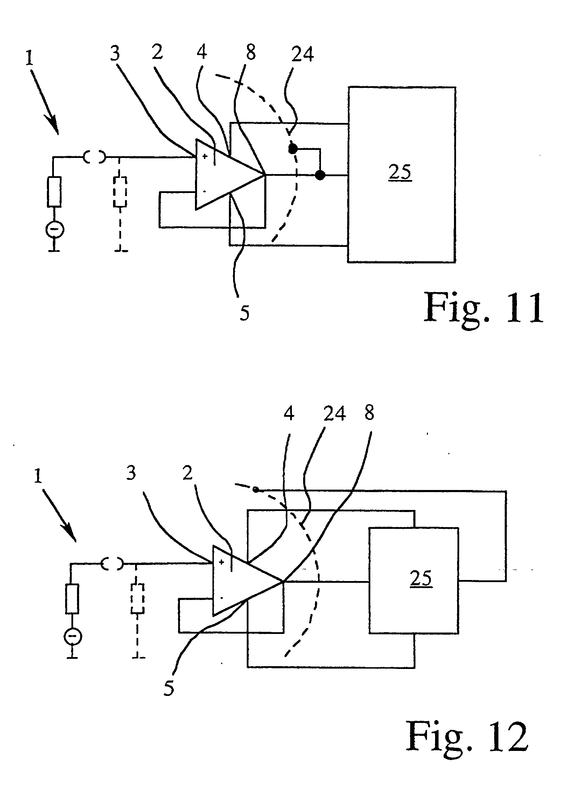

Alternativ dazu ist in Fig. 11 der Zeichnung ein weiteres Ausführungsbeispiel eines Vorverstärkers dargestellt, bei dem die Abschirmung 24 im Bereich des Signalausgangs 8 des Operationsverstärkers 2 angeordnet ist.

Schließlich ist in Fig. 12 der Zeichnung eines weiteres Ausführungsbeispiel eines Vorverstärkers dargestellt, bei dem das Potential der Abschirmung 24 mittelbar von dem Ausgangssignal, also beispielsweise von einem verstärkten Ausgangssignal ansteuerbar ist. Dies ist abhängig von den äußeren Störeinflüssen unter Umständen von Vorteil.

## Patentansprüche

1. Vorverstärker zur Verstärkung von Signalspannungen einer Signalquelle (1) hoher Quellenimpedanz mit einem mit der Signalquelle (1) verbundenen Signaleingang (3), mit einer ersten und mit einem ersten Versorgungsspannungspotential verbundenen Versorgungsspannungsklemme (4), mit einer zweiten und mit einem zweiten Versorgungsspannungspotential verbundenen zweiten Versorgungsspannungsklemme (5) und mit einem ein Ausgangssignal liefernden Signalausgang (8), **dadurch gekennzeichnet, daß** mit dem Signalausgang (8) ein Tiefpaßfilter (21) zum Filtern des Ausgangssignals verbunden ist und das erste und zweite Versorgungsspannungspotential abhängig von dem tiefpaßgefilterten Ausgangssignal parallel verschiebbar sind.

2. Vorverstärker nach Anspruch 1, **dadurch gekennzeichnet, daß** der Vorverstärker als Spannungsfolger ausgebildet ist.

3. Vorverstärker nach Anspruch 1, **dadurch gekennzeichnet, daß** der Vorverstärker die Signalspannung verstärkt.

4. Vorverstärker nach Anspruch 3, **dadurch gekennzeichnet, daß** das erste und zweite Versorgungsspannungspotential unmittelbar abhängig von dem verstärkten Ausgangssignal verschiebbar ist.

5. Vorverstärker nach einem der Ansprüche 1 bis 2, **dadurch gekennzeichnet, daß** das erste und zweite Versorgungsspannungspotential unmittelbar abhängig von dem abgeschwächten Ausgangssignal verschiebbar ist.

6. Vorverstärker nach einem der Ansprüche 1 bis 5, **dadurch gekennzeichnet, daß** das Ausgangssignal unmittelbar als Bezugspotential fiir die das jeweilige Versorgungsspannungspotential liefernden Versorgungsspannungsquellen (9, 10) dient.

7. Vorverstärker nach einem der Ansprüche 1 bis 5, **dadurch gekennzeichnet, daß** das jeweilige Versorgungsspannungspotential über einen Spannungsteiler (13, 14) aus dem Ausgangssignal und dem Potential jeweils einer Versorgungsspannungsquelle (15, 16) ableitbar ist

8. Vorverstärker nach einem der Ansprüche 1 bis 7, **dadurch gekennzeichnet, daß** der Vorverstärker als Operationsverstärker (2) ausgebildet ist.

9. Vorverstärker nach einem der Ansprüche 1 bis 8, **dadurch gekennzeichnet, daß** das Potential einer Abschirmung (24) der Signalquelle (1) von dem Ausgangssignal steuerbar ist.

10. Vorverstärker nach Anspruch 9, **dadurch gekennzeichnet, daß** die Abschirmung (24) zwischen der Signalquelle (1) und dem Signaleingang (3) angeordnet ist.

11. Vorverstärker nach Anspruch 9, **dadurch gekennzeichnet, daß** die Abschirmung (24) im Bereich des Signalausgangs (8) angeordnet ist.

## Claims

1. A preamplifier for amplifying signal voltages from a signal source (1) with high source impedance having a signal input (3) connected to the signal source (1), a first supply voltage terminal (4) connected to a first power supply voltage potential, a second supply voltage terminal (5) connected to a second power supply voltage potential and a signal output (8) supplying an output signal, **characterized in that** a low-pass filter is connected with the signal output and the first and second power supply voltage potentials can be shifted in parallel depending upon the output signal.

2. Preamplifier according to claim 1, **characterized in that** the preamplifier is designed as a voltage sequencer.

3. Preamplifier according to claim 1, **characterized in that** the preamplifier amplifies the signal voltage.

4. Preamplifier according to claim 3, **characterized in that** the first and second supply voltage potentials can be shifted directly depending on the amplified output signal.

5. Preamplifier according to claim 1 or 2, **characterized in that** the first and second supply voltage potentials can be shifted directly depending on the attenuated output signal.

6. Preamplifier according to any one of claims 1 to 4, **characterized in that** the output signal is used directly as a reference potential for the supply voltage sources (9, 10) supplying the respective supply voltage potentials.

7. Preamplifier according to any one of claims 1 to 5, **characterized in that** the respective supply voltage potentials can be drained via an attenuator (13, 14) from the output signal and the potential from a supply voltage source (15, 16).

8. Preamplifier according to any one of claims 1 to 7, **characterized in that** the preamplifier is designed as an operational amplifier (2).

9. Preamplifier according to any one of claims 1 to 8, **characterized in that** the potential of a shield (24) for the signal source (1) can be controlled by the output signal.

10. Preamplifier according to claim 9, **characterized in that** the shield (24) is arranged between the signal source (1) and the signal input (3).

11. The preamplifier according to claim 10, **characterized in that** the shield (24) is arranged near the signal output (8).

## Revendications

1. Préamplificateur pour l'amplification de tensions de signal d'une source de signal (1) d'impédance élevée avec une entrée de signal (3) reliée à la source de signal (1), avec une première borne de tension d'alimentation (4) reliée à un premier potentiel de tension d'alimentation, avec une seconde borne de tension d'alimentation (5) reliée à un second potentiel de tension d'alimentation et avec une sortie du signal (8) fournissant un signal de sortie, **caractérisé en ce qu'**un filtre passe-bas (21) pour le filtrage du signal de sortie est relié à la sortie du signal (8) et **en ce que** les premier et second potentiels de tension d'alimentation peuvent être réglés en parallèle en fonction du signal de sortie filtré avec un passe-bas.

2. Préamplificateur selon la revendication 1, **caractérisé en ce que** le préamplificateur est conçu comme un suiveur de tension.

3. Préamplificateur selon la revendication 1, **caractérisé en ce que** le préamplificateur amplifie la tension du signal.

4. Préamplificateur selon la revendication 3, **caractérisé en ce que** les premier et second potentiels de tension d'alimentation peuvent être réglés directement en fonction du signal de sortie amplifié.

5. Préamplificateur selon l'une quelconque des revendications 1 à 2, **caractérisé en ce que** les premier et second potentiels de tension d'alimentation peuvent être réglés directement en fonction du signal de sortie atténué.

6. Préamplificateur selon l'une quelconque des revendications 1 à 5, **caractérisé en ce que** le signal de sortie sert directement de potentiel de référence pour les sources de tension d'alimentation (9, 10) fournissant le potentiel de tension d'alimentation respectif.

7. Préamplificateur selon l'une quelconque des revendications 1 à 5, **caractérisé en ce que** le potentiel de tension d'alimentation respectif peut être réduit au moyen d'un diviseur de tension (13, 14) du signal de sortie et du potentiel respectivement d'une source de tension d'alimentation (15, 16).

8. Préamplificateur selon l'une quelconque des revendications 1 à 7, **caractérisé en ce que** le préamplificateur est conçu comme un amplificateur opérationnel (2).

9. Préamplificateur selon l'une quelconque des revendications 1 à 8, **caractérisé en ce que** le potentiel d'un blindage (24) de la source de signal (1) peut être contrôlé par le signal de sortie.

10. Préamplificateur selon la revendication 9, **caractérisé en ce que** le blindage (24) est disposé entre la source du signal (1) et l'entrée du signal (3).

11. Préamplificateur selon la revendication 9, **caractérisé en ce que** le blindage (24) est disposé dans la zone de la sortie du signal (8).
